Europäisches Patentamt

European Patent Office

Office européen des brevets

(11) Veröffentlichungsnummer: **0 383 958 B1**

(12) **EUROPÄISCHE PATENTSCHRIFT**

(45) Veröffentlichungstag der Patentschrift: **02.06.93**

(51) Int. Cl.⁵: **H01S 3/103**, H01S 3/08, H01S 3/06

(21) Anmeldenummer: **89102596.7**

(22) Anmeldetag: **15.02.89**

(54) **Abstimmbarer Halbleiterlaser.**

(43) Veröffentlichungstag der Anmeldung:
**29.08.90 Patentblatt 90/35**

(45) Bekanntmachung des Hinweises auf die Patenterteilung:
**02.06.93 Patentblatt 93/22**

(84) Benannte Vertragsstaaten:
**DE ES FR GB IT**

(56) Entgegenhaltungen:
**EP-A- 0 173 269**
**EP-A- 0 296 066**
**EP-A- 0 300 790**
**JP-A-63 272 088**
**US-A- 4 607 370**

**JOURNAL OF OPTICAL COMMUNICATIONS, Band 6, Nr. 2, Juni 1985, Seiten 42-43, Fachverlag Schiele & Schon, Berlin, DE; G. MÜLLER et al.: "Fabrication and characteristics of MCRW GaAs/GaAlAs lasers on semiinsulating substrate"**

(73) Patentinhaber: **SIEMENS AKTIENGESELLSCHAFT**
**Wittelsbacherplatz 2**
**W-8000 München 2(DE)**

(72) Erfinder: **Amann, Markus-Christian, Dr.-Ing.**
**Unterhachinger Strasse 89**
**W-8000 München 83(DE)**
Erfinder: **Baumann, Gerhard G., Dr.rer.nat.**
**Friedenstrasse 6**
**W-8012 Ottobrunn(DE)**
Erfinder: **Heinen, Jochen, Dr.-Ing.**
**Dianastrasse 38**
**W-8013 Haar(DE)**
Erfinder: **Thulke, Wolfgang, Dr. rer. nat.**
**Neubiberger Strasse 38**
**W-8000 München 83(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Für die optische Nachrichtentechnik werden Halbleiterlaser benötigt, bei denen die Wellenlänge des emittierten Lichtes innerhalb gewisser Grenzen einstellbar ist. Diese Einstellung soll stufenlos und sehr schnell erfolgen können, so daß dafür nur elektronische Effekte angewendet werden können. Die Abstimmbarkeit soll in einer Laserstruktur realisiert sein, die mit möglichst geringem technologischem Aufwand herstellbar ist und über eine lange Betriebsdauer hinweg ihre Eigenschaft nicht verändert.

Eine Möglichkeit der Wellenlängenabstimmung besteht in der Änderung der Brechzahl in einem Teil des lichtleitenden Halbleitermaterials durch die Injektion von Ladungsträgern. Ein Halbleiterlaser wird zum Zweck der Abstimmbarkeit durch verschiedene Kontaktbereiche in longitudinaler Richtung in zwei oder mehr Sektionen aufgeteilt, die mit verschieden eingeprägten Strömen angesteuert werden. Mindestens eine Sektion ist dabei als Halbleiterlaser ausgelegt. Die Abstimmung der Wellenlänge erfolgt dann über eine Änderung der effektiven Brechzahl in einem oder mehreren derjenigen Bereiche, die nicht als Halbleiterlaser ausgelegt sind. Ein derartiger Halbleiterlaser ist in EP-A-0 300 790 offenbart. Die Einstellung der Ströme durch diese Sektionen kann nur innerhalb enger Grenzen erfolgen, da die Änderung des Stroms durch eine Sektion den Betriebszustand auch der anderen Sektionen beeinflusst. Daraus folgt, daß ein Nachteil der Mehrsektionslaser neben der komplizierten Herstellungstechnologie die Notwendigkeit ist, mittels eines umfangreichen Meßprogrammes die Verhältnisse der verschiedenen Ströme untereinander zu bestimmen und zu optimieren. Dabei ist zu berücksichtigen, daß durch die Alterung des Mehrsektionslasers die Aufteilung sich verändert, so daß nach einer gewissen Betriebsdauer eine Neubestimmung der Betriebsdaten notwendig wird.

Aufgabe der vorliegenden Erfindung ist es, einen einfach herstellbaren Aufbau für einen abstimmbaren Halbleiterlaser anzugeben, bei dem die Abstimmung möglichst einfach und ohne wesentliche Beeinträchtigung durch Alterungseffekte erfolgen kann.

Diese Aufgabe wird durch einen Aufbau mit den Merkmalen des Anspruches 1 gelöst. Weitere Ausgestaltungen ergeben sich aus den Unteransprüchen.

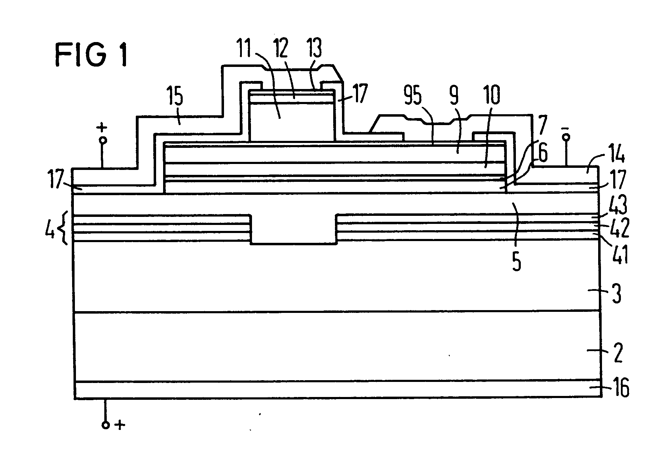

Es folgt eine Beschreibung der Erfindung anhand der Figuren 1 bis 5, die fünf verschiedene Ausführungsbeispiele eines erfindungsgemäßen Aufbaues im Querschnitt zeigen.

Der Laser ist nach dem MCRW-Prinzip (metal clad ridge waveguide), wie in der US-Patentschrift 4 352 187 beschrieben, aufgebaut. Die seitliche Wellenführung zur Begrenzung der Strahlung auf einen streifenförmigen Bereich erfolgt mittels eines über der aktiven Zone angebrachten Steges aus Halbleitermaterial und seitlich davon in der Dicke verminderter Deckschichten.

Bei einem erfindungsgemäßen Halbleiterlaser erfolgt die Abstimmung der Emissionswellenlänge durch das Einstellen der Brechzahl einer gesonderten Halbleiterschicht, der Abstimmschicht, in der Mehrfachheterostruktur durch die Injektion von zusätzlichen Ladungsträgern. Im Gegensatz zu den bekannten Aufbauten mit longitudinaler Anordnung von Abstimmsektoren ist bei dem erfindungsgemäßen Aufbau die Abstimmschicht ober- bzw. unterhalb der aktiven Schicht angeordnet.

Um einmodigen und abstimmbaren Betrieb zu ermöglichen, kann die erfindungsgemäße Laserstruktur ein DFB-Gitter besitzen, das wie die Abstimmschicht über- bzw. unterhalb der aktiven Schicht liegen kann.

Den nachfolgenden Ausführungsbeispielen ist gemeinsam, daß ein einfach herzustellender Aufbau, der eine gesonderte elektrische Ansteuerung der Abstimmschicht ermöglicht, angegeben wird. Gleichzeitig wird die laseraktive Zone auf einen Streifen, der durch einen Stegwellenleiter definiert ist, begrenzt. Die Aufbauten werden jeweils für ein Substrat 2 beschrieben, das für p-Leitung dotiert ist. Bei umgekehrtem Leitungstyp vertauschen sich entsprechend die Vorzeichen der Leitungstypen auch der aufgewachsenen Schichten. Zur Verbesserung der Oberflächenbeschaffenheit ist auf das Substrat 2 eine Pufferschicht 3, die ebenfalls p-leitend dotiert ist aufgewachsen. Darauf folgt eine Sperrschicht 4, die längs eines streifenförmigen Bereiches unterbrochen ist und die zumindest in flächenmäßigen Anteilen n-leitend dotiert ist. Diese Sperrschicht begrenzt den Stromfluß zum Substrat 2 auf den streifenförmigen Bereich, in dem diese Sperrschicht 4 unterbrochen ist. In den in den Figuren 1 bis 5 dargestellten Ausführungsbeispielen besteht diese Sperrschicht 4 jeweils aus einem ersten Schichtanteil 41, einem zweiten Schichtanteil 42 und einem dritten Schichtanteil 43. Der erste Schichtanteil 41 und der zweite Schichtanteil 42 sind jeweils n-leitend, der dritte Schichtanteil 43 ist p-leitend dotiert. Auf die Sperrschicht 4 ist eine Ausgleichsschicht 5, 50 aufgewachsen, die p-leitend dotiert ist und die den streifenförmigen Bereich, in dem die Sperrschicht 4 unterbrochen ist, und eventuell einen streifenförmigen Graben in der Pufferschicht 3, der beim Ausätzen der Sperrschicht 4 entstanden ist, auffüllt.

Über der Ausgleichsschicht 5 befinden sich die auf der dem Substrat abgewandten Seite mit einer Schutzschicht 7 überwachsene aktive Schicht 6 und durch eine Zentralschicht 10 davon getrennt eine auf der dem Substrat abgewandten Seite mit einer ersten Kontaktschicht 95, 950 überwachsene Abstimm-

2

schicht 9, 90. Die Schutzschicht 7 dient nur der Verhinderung einer Durchmischung der aktiven Schicht 6 mit der nachfolgenden Schicht beim epitaktischen Aufwachsen und kann beim Aufwachsen aus der Gasphase auch weggelassen werden. Oberhalb des von der Sperrschicht 4 freigelassenen streifenförmigen Bereiches ist auf der Schichtfolge ein Stegwellenleiter ausgebildet, der aus einer Mantelschicht 11, darauf einer zweiten Kontaktschicht 12 und darauf einem Kontaktstreifen 13 aus Metall gebildet ist. Eine Passivierungsschicht 17 aus einem Dielektrikum, z.B. eine Oxidschicht, läßt einen Bereich auf der ersten Kontaktschicht 95, 950 und einen Bereich längs des Kontaktstreifens 13 frei. Darauf aufgebracht sind ein erster Kontakt 14, der mit der ersten Kontaktschicht 95, 950 in Berührung ist, und ein zweiter Kontakt 15, der mit dem Kontaktstreifen 13 in Berührung ist. Zwischen dem zweiten Kontakt 15 und einem dritten Kontakt 16 auf der freien Unterseite des Substrates wird die Spannung zum Betrieb des Lasers angelegt. Die Ladungsträgerinjektion in die Abstimmschicht 9, 90 erfolgt über den ersten Kontakt 14. Die Mantelschicht 11 und die zweite Kontaktschicht 12 sind für p-Leitung dotiert, wobei die zweite Kontaktschicht 12 für ausreichend niederohmigen Übergang zum Kontaktstreifen 13 hoch dotiert ist. Die Abstimmschicht 9, 90, die erste Kontaktschicht 95, 950 und die Zentralschicht 10 sind n-leitend dotiert, wobei die erste Kontaktschicht 96, 950 für ausreichend niedrigen Widerstand zum ersten Kontakt 14 hin hoch dotiert ist und die Zentralschicht 10 für hinreichend hohe Ladungsträgerdichte und Ladungsträgerbeweglichkeit hoch dotiert ist.

Bei Verwendung eines semiisolierenden Substrats (2) ist der dritte Kontakt (16) auf der Pufferschicht (3) aufgebracht.

In einer in Fig. 1 im Querschnitt dargestellten ersten Ausführungsvariante ist die aktive Schicht 6 mit der darauf befindlichen Schutzschicht 7 auf die Ausgleichsschicht 5 aufgewachsen; darauf folgen die Zentralschicht 10 und die Abstimmschicht 9. In der Zentralschicht 10 kann ein DFB-Gitter eingebaut sein.

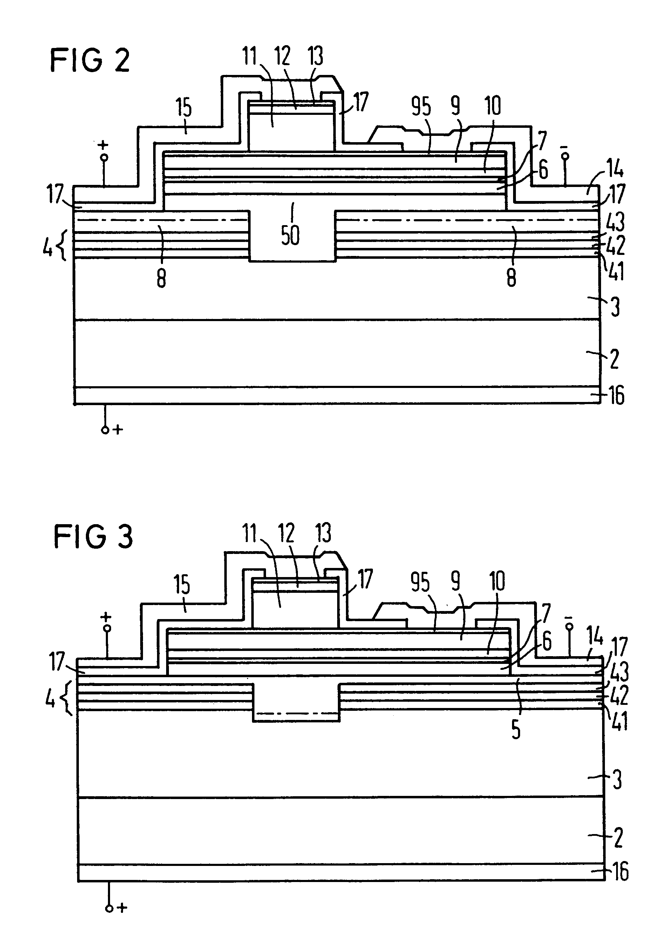

In der in Fig. 2 dargestellten Ausführungsvariante ist eine zusätzliche Gitterschicht 8 mit einem DFB-Gitter zwischen der Sperrschicht 4 und der Ausgleichsschicht 50 vorgesehen. Das Gitter verläuft senkrecht zur Zeichenebene. Die Reihenfolge von aktiver Schicht 6, Schutzschicht 7, Zentralschicht 10, Abstimmschicht 9 und erster Kontaktschicht 95 ist dieselbe wie in Ausführungsvariante 1.

Bei der in Fig. 3 dargestellten dritten Ausführungsvariante ist in der Pufferschicht 3 im Bereich des Stegwellenleiters ein DFB-Gitter ausgebildet.

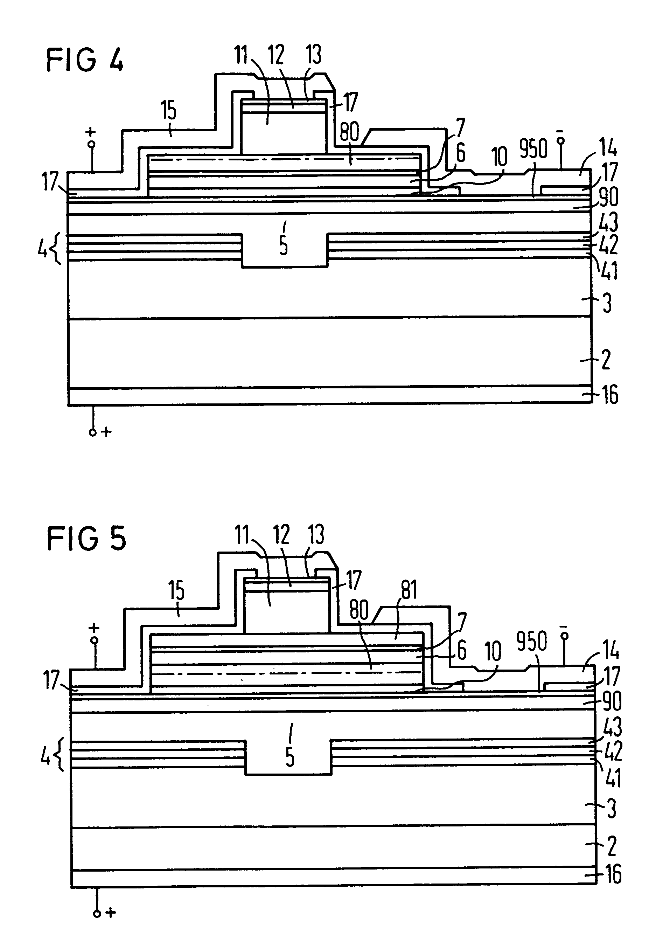

Die beiden Ausführungsvarianten nach Fig. 4 und Fig. 5 unterscheiden sich von den vorhergehenden darin, daß auf der Ausgleichsschicht 5 zunächst die Abstimmschicht 90 ganzflächig und darauf die erste Kontaktschicht 950 aufgewachsen sind. Danach folgen die Zentralschicht 10, die aktive Schicht 6, die Schutzschicht 7 und gegebenenfalls eine Gitterschicht 80, die ein DFB-Gitter enthält. In dem Ausführungsbeispiel nach Fig. 5 ist diese Gitterschicht 80 zwischen der Zentralschicht 10 und der aktiven Schicht 6 angeordnet. Auf der Schutzschicht 7 und unterhalb des Stegwellenleiters ist noch eine Ätzstoppschicht 81 aufgebracht.

Um den gesamten Stromfluß niedrig zu halten, ist die aktive Schicht (6) seitlich auf einen Bereich begrenzt, der die Breite des Stegwellenleiters (maximal etwa 5 $\mu$m, vorzugsweise schmaler) um etwa 2 bis 20 $\mu$m übertrifft.

Eine verbesserte Strahlungseingrenzung auf den Bereich unterhalb des Steges läßt sich erreichen, indem seitlich des Steges die erste Kontaktschicht 95 in den Ausführungsbeispielen der Figuren 1 bis 3 und die Abstimmschicht 9 zumindest teilweise, gegebenenfalls aber ganz, d.h. bis auf die Zentralschicht 10, weggeätzt werden. Unterhalb der Mantelschicht 11 und des ersten Kontaktes 14 bleibt die angegebene Schichtfolge erhalten, aber seitlich des Steges ist die Schichtdicke derart vermindert, daß die Begrenzung der Strahlung auf den Stegbereich verbessert ist.

Zu den angegebenen Schichtdicken ist zu sagen, daß die Strahlungseingrenzung auf den Stegbereich besser ist, wenn die Summe der Dicken der Abstimmschicht 9, der Zentralschicht 10 und der aktiven Schicht 6 zusammengenommen (nach Tabelle 1 ergibt sich ein Wert für diese Dicke von maximal 0,9 $\mu$m) möglichst klein ist. Andererseits darf die Abstimmschicht 9 nicht zu dünn sein, wenn eine wirkungsvolle Abstimmung erreicht werden soll.

Die Zentralschicht 10 wird so dünn wie möglich hergestellt. Die Dotierung muß ausreichend hoch sein, um eine hohe Leitfähigkeit zu gewährleisten. Die Dicke ist nach unten durch die Herstellungsprozesse begrenzt. Es dürfen keine Löcher, die diese Zentralschicht 10 unterbrechen, vorhanden sein. Die untere Grenze von 0,02 $\mu$m für die Dicke und die obere Grenze von $10^{20}$ cm$^{-3}$ für die Dotierungshöhe in Tabelle 1 sind durch den derzeitigen Stand der Technik vorgegeben. Niedrigere Werte für die Dicke und gleichzeitig höhere Werte für die Dotierung der Zentralschicht 10 wären als für die Erfindung vorteilhaft anzusehen.

Je schmaler der Steg und damit die beabsichtigte Strahlungsbegrenzung, umso stärker muß der dem MCRW-Prinzip entsprechende Quasi-Indexsprung am Rand des Steges sein, was einen hinreichend kleinen Abstand der die Strahlung führenden Schichten (Abstimmschicht 9 und aktive Schicht 6) von der Oberfläche bzw. Grenzfläche zur Mantelschicht 11 und damit eine hinreichend kleine Dicke dieser Schichten erforderlich macht. Als Kompromiß hält man die aktive Schicht 6 möglichst dünn, um für die Abstimmschicht 9 noch für wirkungsvolle Abstimmung ausreichend Dicke zur Verfügung zu haben.

Die Strukturparameter der verschiedenen Schichten sind in Tabelle 1 aufgelistet. Diese Tabelle betrifft Ausführungsbeispiele mit InP-Material, wobei Q quaternäres Material bedeutet. Die Abkürzungen bedeuten: ch = chemische Zusammensetzung, c = Leitungstyp, Lambda $_g$ = Wellenlänge, d = Dotierungshöhe, th = Schichtdicke. Die in Klammern gesetzten Zahlen 1 bzw. 2 beziehen sich auf die jeweils vorteilhaft einzuhaltenden Grenzen bzw. ein besonders vorteilhaftes Ausführungsbeispiel. In Tabelle 2 sind die Parameter für die Gitterschicht 8, 80 für die fünf Ausführungsvarianten angegeben.

Tabelle 1: Strukturparameter     möglich (1)   typisch (2)

| Schicht Nr. | ch | c | $\lambda_g/\mu m$ (1) | $d/10^{18}$ cm$^{-3}$ (1) | th/$\mu m$ (1) | $\lambda_g/\mu m$ (2) | $d/10^{18}$ cm$^{-3}$ (2) | th/$\mu m$ (2) |
|---|---|---|---|---|---|---|---|---|
| 2 | InP | p | 0.92 | 5 | 50 ... 200 | 0.92 | 5 | 80 |
| 3. | InP | p | 0.92 | 0.1 ... 5 | 0.5 ... 10 | 0.92 | 1 | 5 |
| 4 | Q | n | 1.00 ... 1.67 | 1 ... 50 | 0.05 ... 1 | 1.30 | 10 | 0.3 |
| 41 | Q | n | 1.00 ... 1.67 | 1 ... 50 | 0.05 ... 0.5 | 1.30 | 10 | 0.15 |
| 42 | InP | n | 0.92 | 1 ... 50 | 0.05 ... 0.5 | 0.92 | 10 | 0.15 |
| 43 | InP | p | 0.92 | 0.1 ... 5 | 0.05 ... 0.5 | 0.92 | 0.5 | 0.15 |
| 5 | InP | p | 0.92 | 0.1 ... 5 | 0.1 ... 5 | 0.92 | 0.3 | 1 |
| 6 | Q | - | 1.30 ... 1.67 | ---- | 0.05 ... 0.2 | 1.55 | --- | 0.1 |
| 7 | Q | - | 1.00 ... 1.67 | ---- | 0.01 ... 0.1 | 1.30 | --- | 0.03 |
| 81 | Q | p | 1.00 ... 1.67 | 0.1 ... 5 | 0.05 ... 0.5 | 1.15 | 0.5 | 0.1 |
| 9 | Q | n | 1.00 ... 1.67 | 0.05 ... 5 | 0.1 ... 0.5 | 1.40 | 0.2 | 0.2 |
| 95 | Q | n | 1.00 ... 1.67 | 2 ... 100 | 0.02 ... 0.5 | 1.15 | 20 | 0.1 |
| 10 | InP | n | 0.92 ... | 2 ... 100 | 0.02 ... 0.2 | 0.92 | 20 | 0.15 |
| 11 | InP | p | 0.92 | 0.1 ... 5 | 0.5 ... 5 | 0.92 | 0.5 | 1.5 |
| 12 | Q | p | 1.00 ... 1.67 | 0.5 ... 50 | 0.05 ... 0.5 | 1.30 | 5 | 0.2 |

EP 0 383 958 B1

Tabelle 2: Parameter Schicht Nr. 8, 80

| Variante | ch | c | möglich (1) | | | typisch (2) | | |
|---|---|---|---|---|---|---|---|---|
| | | | $\lambda_g/\mu m$ (1) | $d/10^{18}\,cm^{-3}$ (1) | $th/\mu m$ (1) | $\lambda_g/\mu m$ (2) | $d/10^{18}\,cm^{-3}$ (2) | $th/\mu m$ (2) |
| 1 | InP | n | 0.92 | 2 ... 100 | 0.05 ... 0.5 | 0.92 | 20 | 0.15 |
| 2 | Q | p | 1.00 ... 1.67 | 0.1 ... 10 | 0.05 ... 0.5 | 1.15 | 0.5 | 0.15 |
| 3 | InP | p | 0.92 | 0.1 ... 10 | 0.05 ... 10 | 0.92 | 1 | 5 |
| 4 | Q | p | 1.00 ... 1.67 | 0.05 ... 5 | 0.05 ... 0.5 | 1.15 | 0.2 | 0.15 |
| 5 | Q | n | 1.00 ... 1.67 | 0.05 ... 5 | 0.01 ... 0.5 | 1.15 | 0.2 | 0.05 |

**Patentansprüche**

1. Abstimmbarer Halbleiterlaser mit einem Substrat (2),
   - mit einer aktiven Schicht (6),
   - mit einer Abstimmschicht (9),

- mit einem ersten Kontakt (14), einem zweiten Kontakt (15) und einem dritten Kontakt (16), dadurch **gekennzeichnet,**
- daß die aktive Schicht (6) und die Abstimmschicht (9,90) übereinander angeordnet sind,
- daß die aktive Schicht (6) und die Abstimmschicht (9,90) durch eine Zentralschicht (10) aus Halbleitermaterial getrennt sind, die als Stromleiter vorgesehen ist,
- daß diese Zentralschicht (10) dazu relativ dünn ist und relativ hoch dotiert ist, um eine relativ hohe Ladungsträgerdichte und damit verbundene elektrische Leitfähigkeit dieser Zentralschicht (10) zu gewährleisten,
- daß eine durch einen streifenförmigen Bereich unterbrochene Sperrschicht (4) vorgesehen ist für eine laterale Eingrenzung des Stromflusses auf diesen streifenförmigen Bereich,
- daß die Abstimmschicht (9,90) auf der dem Substrat abgewandten Seite dieser Sperrschicht (4) angeordnet ist,
- daß auf der Abstimmschicht (9, 90) eine erste Kontaktschicht (95, 950) und darauf der erste Kontakt (14) aufgebracht sind,
- daß über dem Bereich, in dem die Sperrschicht (4) unterbrochen ist, ein Stegwellenleiter (11,12,13) nach dem MCRW-Prinzip ausgebildet ist,
- daß dieser Stegwellenleiter durch eine streifenförmige Mantelschicht (11), eine darauf aufgebrachte zweite Kontaktschicht (12) und einen darauf aufgebrachten Kontaktstreifen (13) aus Metall gebildet ist,
- daß der zweite Kontakt (15) auf diesem Kontaktstreifen (13) aufgebracht ist,
- daß auf der dem zweiten Kontakt (15) gegenüberliegenden Seite der Sperrschicht (4) der dritte Kontakt (16) aufgebracht ist,
- daß die Mantelschicht (11) und die zweite Kontaktschicht (12) für elektrische Leitung eines ersten Leitungstyps dotiert sind und
- daß die Abstimmschicht (9, 90), die erste Kontaktschicht (95, 950), die Zentralschicht (10) und wenigstens Schichtanteile der Sperrschicht (4) für elektrische Leitung eines entgegengesetzten zweiten Leitungstyps dotiert sind.

2. Halbleiterlaser nach Anspruch 1, dadurch **gekennzeichnet,**
   - daß auf das Substrat (2) nacheinander eine Pufferschicht (3), die Sperrschicht (4) und eine die Sperrschicht (4) planarisierende Ausgleichsschicht (5, 50) aufgewachsen sind,
   - daß diese Pufferschicht (3) und diese Ausgleichsschicht (5) für elektrische Leitung des ersten Leitungstyps dotiert sind und
   - daß die aktive Schicht (6) auf ihrer dem Substrat (2) abgewandten Seite mit einer Schutzschicht (7) überwachsen ist.

3. Halbleiterlaser nach Anspruch 2,
   **dadurch gekennzeichnet,**
   daß zwischen der Sperrschicht (4) und der Ausgleichsschicht (5) eine Gitterschicht (8) mit einem DFB-Gitter aufgewachsen ist.

4. Halbleiterlaser nach Anspruch 2,
   **dadurch gekennzeichnet,**
   daß die Pufferschicht (3) zumindest im Bereich des Stegwellenleiters ein DFB-Gitter enthält.

5. Halbleiterlaser nach Anspruch 2,
   **dadurch gekennzeichnet,**
   daß zwischen der Ausgleichsschicht (5) und dem Stegwellenleiter eine Gitterschicht (80) mit einem DFB-Gitter aufgewachsen ist.

6. Halbleiterlaser nach einem der Ansprüche 1 bis 5,
   **dadurch gekennzeichnet,**
   daß erste Leitungstyp p-Leitung und der zweite Leitungstyp n-Leitung ist.

7. Halbleiterlaser nach einem der Ansprüche 1 bis 5,
   **dadurch gekennzeichnet,**
   daß der erste Leitungstyp n-Leitung und der zweite Leitungstyp p-Leitung ist.

8. Halbleiterlaser nach einem der Ansprüche 1 bis 7,
**dadurch gekennzeichnet,**
daß die Zentralschicht (10) ein DFB-Gitter enthält.

9. Halbleiterlaser nach einem der Ansprüche 1 bis 8,
**dadurch gekennzeichnet,**
daß die aktive Schicht (6) vor der Abstimmschicht (9) aufgewachsen ist.

10. Halbleiterlaser nach einem der Ansprüche 1 bis 8,
**dadurch gekennzeichnet,**
daß die Abstimmschicht (90) vor der aktiven Schicht (6) aufgewachsen ist.

11. Halbleiterlaser nach einem der Ansprüche 1 bis 10,
**dadurch gekennzeichnet,**
- daß eine Passivierungsschicht (17) aus einem Dielektrikum unter dem ersten Kontakt (14) und dem zweiten Kontakt (15) aufgebracht ist und
- daß diese Passivierungsschicht (17) für die Kontaktierung vorgesehene Bereiche auf der ersten Kontaktschicht (95,950) und auf dem Kontaktstreifen (13) frei läßt.

12. Halbleiterlaser nach einem der Ansprüche 1 bis 11,
**dadurch gekennzeichnet,**
daß das Substrat (2) für elektrische Leitung des ersten Leitungstyps dotiert ist und
daß der dritte Kontakt (16) auf der freien Unterseite des Substrates (2) aufgebracht ist.

## Claims

1. Tunable semiconductor laser comprising a substrate (2), an active layer (6), a tuning layer (9), a first contact (14), a second contact (15), and a third contact (16), characterised in that the active layer (6) and the tuning layer (9, 90) are arranged one above another, in that the active layer (6) and the tuning layer (9,90) are separated by a central layer (10) made from semiconductor material and provided as a current conductor, in that, in addition, this central layer (10) is relatively thin and relatively highly doped, in order to ensure for this central layer (10) a relatively high charge carrier density and electrical conductivity associated therewith, in that a barrier layer (4) which is interrupted by a strip-shaped region is provided for a lateral limitation of the current flow onto this strip-shaped region, in that the tuning layer (9, 90) is arranged on the side of this barrier layer (4) averted from the substrate, in that there is applied to the tuning layer (9, 90) a first contact layer (95, 950) and thereon the first contact (14), in that a ridge waveguide (11, 12, 13) is constructed according to the MCRW principle above the region in which the barrier layer (4) is interrupted, in that this ridge waveguide is formed by a strip-shaped cladding layer (11), a second contact layer (12) applied thereon and a contact strip (13) made from metal and applied thereon, in that the second contact (15) is applied to this contact strip (13), in that the third contact (16) is applied on the side of the barrier layer (4) opposite the second contact (15), in that the cladding layer (11) and the second contact layer (12) are doped for electrical conduction of a first conduction type, and in that the tuning layer (9, 90), the first contact layer (95, 950), the central layer (10) and at least layer components of the barrier layer (4) are doped for electrical conduction of an opposite second conduction type.

2. Semiconductor laser according to Claim 1, characterised in that a buffer layer (3), the barrier layer (4) and a balancing layer (5, 50) which planarises the barrier layer (4) are successively grown onto the substrate (2), in that this buffer layer (3) and this balancing layer (5) are doped for electrical conduction of the first conduction type, and in that the active layer (6) is overgrown by a protective layer (7) on its side averted from the substrate (2).

3. Semiconductor laser according to Claim 2, characterised in that a lattice layer (8) having a DFB lattice is grown on between the barrier layer (4) and the balancing layer (5).

4. Semiconductor laser according to Claim 2, characterised in that the buffer layer (3) contains a DFB lattice at least in the region of the ridge waveguide.

**5.** Semiconductor layer according to Claim 2, characterised in that a lattice layer (80) having a DFB lattice is grown on between the balancing layer (5) and the ridge waveguide.

**6.** Semiconductor laser according to one of Claims 1 to 5, characterised in that the first conduction type is p-conduction and the second conduction type is n-conduction.

**7.** Semiconductor laser according to one of Claims 1 to 5, characterised in that the first conduction type is n-conduction and the second conduction type is p-conduction.

**8.** Semiconductor laser according to one of Claims 1 to 7, characterised in that the central layer (10) contains a DFB lattice.

**9.** Semiconductor laser according to one of Claims 1 to 8, characterised in that the active layer (6) is grown on before the tuning layer (9).

**10.** Semiconductor laser according to one of Claims 1 to 8, characterised in that the tuning layer (90) is grown on before the active layer (6).

**11.** Semiconductor laser according to one of Claims 1 to 10, characterised in that a passivation layer (17) made from a dielectric is applied under the first contact (14) and the second contact (15), and in that this passivation layer (17) leaves free regions provided for contacting on the first contact layer (95, 950) and on the contact strip (13).

**12.** Semiconductor laser according to one of Claims 1 to 11, characterised in that the substrate (2) is doped for electrical conduction of the first conduction type, and in that the third contact (16) is applied to the free underside of the substrate (2).

**Revendications**

**1.** Laser à semiconducteurs accordable, avec un substrat (2), comportant
- une couche active (6),
- une couche de réglage de l'accord (9),
- un premier contact (14), un second contact (15) et un troisième contact (16),
caractérisé par le fait
- que la couche active (6) et la couche de réglage de l'accord (9,90) sont superposées,
- que la couche active (6) et la couche de réglage de l'accord (9,90) sont séparées par une couche centrale (10) formée d'un matériau semiconducteur et prévue en tant que conducteur,
- que cette couche centrale (10) est relativement mince et est relativement fortement dopée de manière à garantir une densité relativement élevée de porteurs de charges et une conductibilité électrique relativement élevée, qui y est liée, de cette couche centrale (10),
- qu'il est prévu une couche de blocage (4) interrompue par une zone en forme de bande et servant à limiter latéralement le flux de courant dans cette zone en forme de bande,
- que la couche de réglage d'accord (9,90) est disposée sur la face de cette couche de blocage (4), tournée à l'opposé du substrat,
- que sur la couche de réglage d'accord (9,90) est disposée une première couche de contact (95,950), sur laquelle est disposé le premier contact (14),
- qu'un guide d'ondes en forme de barreau (11,12,13) est réalisé selon le principe MCRW au-dessus de la zone, dans laquelle la couche de blocage (4) est interrompue,
- que ce guide d'ondes en forme de barreau est formé par une couche enveloppe en forme de bande (11), une seconde couche de contact (12) déposée sur la couche précédente et une bande de contact métallique déposée sur la couche de contact,
- que le second contact (15) est disposé sur cette bande de contact (13),
- que le troisième contact (16) est déposé sur la face de la couche de blocage (4), située en vis-à-vis du second contact (15),
- que la couche enveloppe (11) et la seconde couche de contact (12) sont dopées pour fournir une conduction électrique avec un premier type de conduction, et
- que la couche de réglage d'accord (9,90), la première couche de contact (95,950), la couche centrale (10) et au moins des parties de la couche de blocage (4) sont dopées pour fournir la conduction électrique avec un second type de conduction opposé.

**2.** Laser à semiconducteurs suivant la revendication 1, caractérisé par le fait
- que sur le substrat (2) sont formées successivement, par croissance, une couche tampon (3), la couche de blocage (4) et une couche de compensation (5,50) qui planarise la couche de blocage (4),
- que cette couche tampon (3) et cette couche de compensation (5) sont dopées pour fournir la conduction électrique avec le premier type de conduction, et
- que la couche active (6) est recouverte par une couche de protection (7), sur sa face tournée à l'opposé du substrat (2).

**3.** Laser à semiconducteurs suivant la revendication 2, caractérisé par le fait qu'une couche (8) comportant un réseau DFB est formée par croissance entre la couche de blocage (4) et la couche de compensation (5).

**4.** Laser à semiconducteurs suivant la revendication 2, caractérisé par le fait que la couche tampon (3) comporte un réseau DFB au moins dans la zone du guide d'ondes en forme de barreau.

**5.** Laser à semiconducteurs suivant la revendication 2, caractérisé par le fait qu'une couche (80) comportant un réseau DFB est formée par croissance entre la couche de compensation (5) et le guide d'ondes en forme de barreau.

**6.** Laser à semiconducteurs suivant l'une des revendications 1 à 5, caractérisé par le fait que le premier type de conduction est la conduction de type p et que le second type de conduction est la conduction de type n.

**7.** Laser à semiconducteurs suivant l'une des revendications 1 à 5, caractérisé par le fait que le premier type de conduction est la conduction de type n et le second type de conduction est la conduction de type p.

**8.** Laser à semiconducteurs suivant l'une des revendications 1 à 7, caractérisé par le fait que la couche centrale (10) comporte un réseau DFB.

**9.** Laser à semiconducteurs suivant l'une des revendications 1 à 8, caractérisé par le fait que la couche active (6) est formée par croissance avant la couche de réglage d'accord (9).

**10.** Laser à semiconducteurs suivant l'une des revendications 1 à 8, caractérisé par le fait que la couche de réglage (90) est formée par croissance avant la couche active (6).

**11.** Laser à semiconducteurs suivant l'une des revendications 1 à 10, caractérisé par le fait
- qu'une couche de passivation (17) formée d'un diélectrique est déposée au-dessous du premier contact (14) et du second contact (15), et
- que cette couche de passivation (17) dégage des zones, qui sont prévues pour l'établissement du contact, sur la première couche de contact (95,950) et sur la bande de contact (13).

**12.** Laser à semiconducteurs suivant l'une des revendications 1 à 11, caractérisé par le fait
que le substrat (2) est dopé pour fournir la conduction électrique du premier type, et
que le troisième contact (16) est déposé sur la face inférieure libre du substrat (2).

FIG 1

## FIG 2

## FIG 3

FIG 4

FIG 5